# EUROPEAN PATENT APPLICATION

(11) **EP 3 205 625 A1**
(43) Date of publication of application: **16.08.2017**
(21) Application number: 17151462.3
(22) Date of filing: 13.01.2017
(51) Int. Cl.: C01B 33/02, C23C 16/02, H01L 21/02, H01L 21/20, H01L 21/762

(54) **POLYCRYSTALLINE SILICON AND METHOD FOR SELECTING POLYCRYSTALLINE SILICON**

(30) Priority: 12.02.2016 JP 2016024851
(71) Applicant: Shin-Etsu Chemical Co., Ltd., Tokyo 100-0004 (JP)
(72) Inventor: Netsu, Shigeyoshi, Joetsu-shi, Niigata 9428601 (JP); Miyao, Shuichi, Joetsu-shi, Niigata 9428601 (JP)
(74) Representative: WP Thompson

(57) **Abstract**

An object of the present invention is to provide a method for comparatively simply selecting polycrystalline silicon suitably used for stably producing single crystal silicon in high yield. According to the present invention, polycrystalline silicon having a maximum surface roughness (Peak-to-Valley) value Rpv of 5000 nm or less, an arithmetic average roughness value Ra of 600 nm or less and a root mean square roughness value Rq of 600 nm or less, the surface roughness values being measured by observing with an atomic force microscope (AFM) the surface of a collected plate-shaped sample, is selected as a raw material for producing single crystal silicon.

## Description

### BACKGROUND OF THE INVENTION

### Field of the Invention

The present invention relates to a technique for producing polycrystalline silicon, and more particularly, it relates to a technique for evaluating polycrystalline silicon suitably used for stable production of single crystal silicon.

### Description of the Related Art

Single crystal silicon indispensable for production of semiconductor devices and the like is obtained through crystal growth by a CZ method or an FZ method, and a polycrystalline silicon rod or a polycrystalline silicon mass is used as a raw material in the production. In many cases, such a polycrystalline silicon material is produced by the Siemens process. In the Siemens process, a silane material gas such as trichlorosilane or monosilane is brought into contact with a heated silicon core wire, so as to vapor phase deposit (separate) polycrystalline silicon on the surface of the silicon core wire by CVD (Chemical Vapor Deposition), and thus, polycrystalline silicon is obtained.

For producing single crystal silicon from a raw material of polycrystalline silicon, the two methods of the CZ method and the FZ method are employable. When the CZ method is employed for growing single crystal silicon, a polycrystalline silicon mass is charged in a quartz crucible to be melted by heating to obtain a silicon melt, and a seed crystal is immersed in the silicon melt to eliminate a dislocation line (namely, to change it to be dislocation-free), and thereafter, the crystal is pulled up with its size gradually increased to a desired diameter. Here, if there remains an unmelted piece of the polycrystalline silicon in the silicon melt, the unmelted polycrystalline piece drifts about in the vicinity of a solid-liquid interface, and induces generation of dislocation to cause a crystal line to disappear.

Japanese Patent Laid-Open No. 2008-285403 has pointed out the following problem: During the production of a polycrystalline silicon rod by the Siemens process, a needle crystal is separated in the rod in some cases, and if such a polycrystalline silicon rod is used for the growth of single crystal silicon by the FZ method, individual crystallites are not homogenously melted because they are melted in a manner depending on their sizes. Therefore, some unmelted crystallites pass, in the form of a solid particle, through a melting zone into a single crystal rod to be formed, and are incorporated into a solidified surface of the single crystal, resulting in causing defect formation.

In order to cope with this problem, Japanese Patent Laid-Open No. 2008-285403 proposes the following method: A sample surface cut from a polycrystalline silicon rod vertically to the lengthwise direction is ground or polished to increase contrast to an extent that a microcrystal of the tissue can be visually recognized, under an optical microscope, after the etching, and thus, the size and the area ratio of a needle crystal are measured.

On the basis of the measurement result thus obtained, it is determined whether or not the polycrystalline silicon rod is suitable as a raw material for growing single crystal silicon by the FZ method.

In the visual determination under an optical microscope as in the method disclosed in Japanese Patent Laid-Open No. 2008-285403, however, a difference can be easily caused in the result depending on the degree of the etching of a sample surface to be observed or the observation skill and the like of an evaluator, and in addition, this method is poor in quantitativeness and reproducibility. Therefore, from the viewpoint of increasing the production yield of single crystal silicon, it is necessary to set a rather high criterion for quality determination of polycrystalline silicon used as a raw material, and hence, a rejection rate of polycrystalline silicon rods is unavoidably increased.

Besides, according to the study made by the present inventors, when the method disclosed in Japanese Patent Laid-Open No. 2008-285403 is employed, even if a polycrystalline silicon rod determined as good is used, dislocation may be caused during the growth of a single crystal silicon rod by the FZ method to cause a crystal line to disappear in some cases. On the other hand, even if a polycrystalline silicon rod determined as poor is used, single crystal may be satisfactorily obtained by the FZ method in some cases.

As described above, polycrystalline silicon is used in the two kinds of methods, the CZ and FZ methods. In the CZ method, a polycrystalline silicon rod is crushed into a size of a nugget, and then totally melted to obtain a melt, and a single crystal is pulled up by using a seed crystal from the melt. When this method is employed, the probability of the disappearance of a crystal line is lower than in employing the FZ method in which a melting region is small.

In other words, the FZ method requires a crystal grain having higher quality crystallinity, having an optimal crystal grain size, and having a uniform size as compared with the CZ method, and it is significant to select polycrystalline silicon meeting with these requirements of the respective methods.

Accordingly, in order to stably produce single crystal silicon in high yield, an advanced technique for selecting polycrystalline silicon suitably used as a raw material for producing single crystal silicon with high quantitativeness and reproducibility is demanded.

The present invention was devised in consideration of these circumstances, and an object of the present invention is to provide a technique for selecting, with high quantitativeness and reproducibility, polycrystalline silicon suitably used as a raw material for producing single crystal silicon to make a contribution to stable production of single crystal silicon.

### SUMMARY OF THE INVENTION

In order to solve the above-described problem, the polycrystalline silicon according to the present invention has a maximum surface roughness value Rpv (Peak-to-Valley) of 5000 nm or less, an arithmetic average roughness value Ra of 600 nm or less and a root mean square roughness value Rq of 600 nm or less, the surface roughness values being measured by observing with an atomic force microscope (AFM) a surface of a collected plate-shaped sample.

Preferably, the value Rpv is 2500 nm or less, the value Ra is 300 nm or less, and the value Rq is 300 nm or less, and more preferably, the value Rpv is 2000 nm or less, the value Ra is 100 nm or less, and the value Rq is 150 nm or less.

In a method for selecting polycrystalline silicon according to the present invention, a plate-shaped sample is cut out from a polycrystalline silicon mass; a surface of the plate-shaped sample is subjected to a lapping treatment with an abrasive; the surface of the plate-shaped sample resulting from the lapping treatment is subjected to an etching treatment with a mixture of hydrofluoric acid and nitric acid; surface roughness of the surface of the plate-shaped sample resulting from the etching treatment is evaluated through observation with an atomic force microscope (AFM); and when a maximum surface roughness value Rpv is 5000 nm or less, an arithmetic average roughness value Ra is 600 nm or less and a root mean square roughness value Rq is 600 nm or less, the polycrystalline silicon mass is evaluated as good.

Preferably, the value Rpv is 2500 nm or less, the value Ra is 300 nm or less, and the value Rq is 300 nm or less, and more preferably, the value Rpv is 2000 nm or less, the value Ra is 100 nm or less, and the value Rq is 150 nm or less.

In order to stably produce single crystal silicon in high yield, the size of a crystal grain of polycrystalline silicon used as a raw material is significant, and the crystal grain needs to have an optimal size in accordance with a production method to be employed. The present invention provides a method for comparatively simply selecting polycrystalline silicon suitably used for stably producing single crystal silicon in high yield.

### BRIEF DESCRIPTION OF THE DRAWING

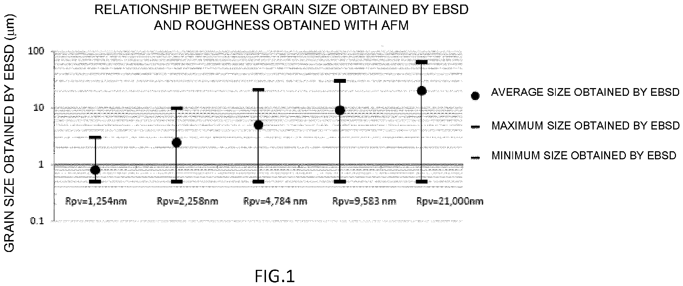

FIG. 1 is a graph illustrating correlation between a surface roughness value, which is obtained by observing with an atomic force microscope (AFM) a surface of a plate-shaped sample cut out from a polycrystalline silicon mass, and a crystal grain size value evaluated by an EBSD method.

### DETAILED DESCRIPTION OF THE PREFERRED EMBODIMENTS

Through analysis and study of polycrystalline silicon used as a raw material for stably producing single crystal silicon, the present inventors have found that the size of a crystal grain contained in polycrystalline silicon is varied in accordance with various conditions employed in separation of the polycrystalline silicon.

Differently from single crystal silicon, polycrystalline silicon contains crystal grains having random crystal orientations, and in general, the size of each crystal grain varies from roughly about several micrometers to several tens micrometers, and may be as large as several hundred micrometers in some cases.

As a method for measuring the size of a crystal grain of each crystal orientation in a polycrystal, an EBSD (electron backscatter diffraction image) method is known. In order to measure a crystal grain size by this method, however, it is necessary to introduce an expensive apparatus, which disadvantageously increases the production cost.

Alternatively, a crystal grain size can be measured with an optical microscope or an electron microscope, but it is necessary to obtain a size distribution by digital processing of an observed surface image in this case, and hence, the thus obtained value does not reflect a true crystal grain size in many cases. This is for the following reason: In binarization performed in image processing, if an image is observed with an optical microscope (a polarizing microscope using a metallograph), influence of lighting and light reflected on a sample surface cannot be ignored. Alternatively, if an electron microscope is used for the observation, it is necessary to change image processing conditions to be employed every time a portion of an image where crystal grains are continued is to be processed.

While conducting various studies on a simple method for measuring a crystal grain size, the present inventors have found that a surface roughness value obtained by observing with an atomic force microscope (AFM) a surface of a plate-shaped sample cut out from a polycrystalline silicon mass is well correlated with a crystal grain size evaluated by the EBSD method, and thus, the present invention was accomplished.

It was confirmed that high yield can be obtained in the CZ method when polycrystalline silicon having a maximum surface roughness (Peak-to-Valley) value Rpv of 5000 nm or less, an arithmetic average roughness value Ra of 600 nm or less and a root mean square roughness value Rq of 600 nm or less, the surface roughness values being measured by observing with an atomic force microscope (AFM) a surface of a collected plate-shaped sample, is used as a raw material for producing single crystal silicon.

Besides, it was confirmed that high yield can be obtained in both the CZ method and the FZ method when polycrystalline silicon having the value Rpv of 2500 nm or less, the value Ra of 300 nm or less and the value Rq of 300 nm or less is used as the raw material for producing signal crystal silicon.

Furthermore, it was confirmed that the yield obtained in the FZ method can be increased up to substantially 100% when polycrystalline silicon having the value Rpv of 2000 nm or less, the value Ra of 100 nm or less and the value Rq of 150 nm or less is used as the raw material for producing single crystal silicon.

Accordingly, in a method for selecting polycrystalline silicon according to the present invention, a plate-shaped sample is cut out from a polycrystalline silicon mass; a surface of the plate-shaped sample is subjected to a lapping treatment with an abrasive; the surface of the plate-shaped sample resulting from the lapping treatment is subjected to an etching treatment with a mixture of hydrofluoric acid and nitric acid; surface roughness of the surface of the plate-shaped sample resulting from the etching treatment is evaluated through observation with an atomic force microscope (AFM); and when a maximum surface roughness value Rpv is 5000 nm or less, an arithmetic average roughness value Ra is 600 nm or less and a root mean square roughness value Rq is 600 nm or less, the polycrystalline silicon mass is evaluated as good.

As described above, if polycrystalline silicon having the value Rpv of 2500 nm or less, the value Ra of 300 nm or less and the value Rq of 300 nm or less is selected as a raw material, high yield can be obtained in both the CZ method and the FZ method.

Furthermore, if polycrystalline silicon having the value Rpv of 2000 nm or less, the value Ra of 100 nm or less and the value Rq of 150 nm or less is selected as a raw material, the yield obtained in the FZ method can be increased up to substantially 100%.

### EXAMPLES

Now, examples of the application of the present invention to a polycrystalline silicon rod synthesized by the Siemens process will be described. A core sample with a diameter of 19 mm (having a length of 130 mm) was collected from each polycrystalline silicon rod, produced by the Siemens process, in a direction vertical to the lengthwise direction (vertical direction). Besides, three core samples each with the same diameter (having a length of 130 mm) were similarly collected, in a direction parallel to the lengthwise direction, respectively from a region close to the core, a region corresponding to a half of the radius (R/2) of the polycrystalline silicon rod, and a region close to the outer surface thereof. Incidentally, four polycrystalline silicon rods A, B, C and D were prepared for the examples, and it is noted that these rods were obtained by separating polycrystalline silicon under different conditions.

From each of these core samples, plate-shaped samples each having a thickness of about 2 mm were cut out at equal intervals. These plate-shaped samples are regarded to respectively represent a distribution in the crystal growth direction and a distribution in the lengthwise direction.

One surface of each of these plate-shaped samples was polished with a #600 abrasive to remove a thickness of about 50 to 60 µm, followed by etching with fluonitric acid. A thickness removed by this etching was 20 to 30 µm. Thereafter, the surface roughness was measured with an AFM to evaluate a crystal grain of the sample. An apparatus used for the measurement with the AFM was Park NX200 manufactured by Park Systems Japan. As a cantilever, OMCL-AC160TS-R3 manufactured by Olympus Corporation, including a probe with a tip radius of 7 nm and made of silicon single crystal (n-doped and having resistivity of 0.1 to 0.4 Ω-cm), was used. Besides, the surface roughness was measured in the whole region of 90 µm x 90 µm on the surface of the sample.

The measurement results are listed in Table 1. It is noted that values Rpv, Ra and Rq shown in the table as degrees of the surface roughness respectively correspond to the maximum surface roughness value Rpv (Peak-to-Valley), the arithmetic average roughness value Ra and the root mean square roughness value Rq.

**[Table 1]**

| Sample evaluated | | Surface parallel to lengthwise direction | | | Surface vertical to lengthwise direction | | | For solar cells | For semiconductors | | Number of rods evaluated |
|---|---|---|---|---|---|---|---|---|---|---|---|
| | | Rpv (nm) | Ra (nm) | Rq (nm) | Rpv (nm) | Ra (nm) | Rq (nm) | CZ | CZ | FZ | |
| Comparative Example | A | 9,583 | 1,235 | 1,458 | 9,254 | 1,120 | 1,298 | ○ | × | × | 68 |
| Example 1 | B | 4,784 | 498 | 554 | 4,687 | 408 | 591 | ○ | ○ | × | 41 |
| Example 2 | C | 2,258 | 264 | 298 | 2,221 | 219 | 279 | ○ | ○ | ○ | 87 |
| Example 3 | D | 1,254 | 78 | 112 | 1,157 | 99 | 128 | ○ | ○ | ⊚ | 39 |

These polysilicon rods A to D were used as raw materials to grow single crystal silicon by the CZ method and the FZ method to examine the yields thus obtained.

In using the polycrystalline silicon rod A, there arose no problem in the pulling up performed in a CZ method for obtaining single crystal silicon for solar cells (hereinafter simply referred to as the CZ method for solar cells), but a crystal line disappeared in the middle of a CZ method for obtaining single crystal silicon for semiconductors (hereinafter simply referred to as the CZ method for semiconductors). This is probably because the polycrystalline silicon rod A had a large crystal grain.

In using the polycrystalline silicon rod B, there arose no problem in the pulling up performed in the CZ method for semiconductors, but a crystal line disappeared in the middle of the formation of single crystal in an FZ method for obtaining single crystal silicon for semiconductors (hereinafter simply referred to as the FZ method for semiconductors). This is probably because the polycrystalline silicon rod B had a crystal grain too large to be employed in the FZ method.

In using the polycrystalline silicon rod C, there arose no problem in the formation of single crystal by the CZ method and the FZ method for semiconductors, but a crystal line disappeared in the middle of the formation of single crystal by the FZ method, and the disappeared length was not 100% but 70% of the entire length.

In using the polycrystalline silicon rod D, a crystal line did not disappear in the middle of the formation of single crystal by the FZ method for semiconductors.

It is understood from these results that the size of a crystal grain of polycrystalline silicon used as a raw material is significant to stably produce single crystal silicon in high yield, that the crystal grain needs to have an optimal size in accordance with either of the production methods to be employed, and that the determination (selection) can be made by a comparatively simple method of surface roughness evaluation by a method using an AFM.

As a result of these various examinations, the present inventors have reached the following conclusions:

High yield can be obtained in the CZ method when polycrystalline silicon having a maximum surface roughness (Peak-to-Valley) value Rpv of 5000 nm or less, an arithmetic average roughness value Ra of 600 nm or less and a root mean square roughness value Rq of 600 nm or less, the surface roughness values being measured by observing with an atomic force microscope (AFM) a surface of a collected plate-shaped sample, is used as a raw material for producing single crystal silicon.

Besides, high yield can be obtained in both the CZ method and the FZ method when polycrystalline silicon having the value Rpv of 2500 nm or less, the value Ra of 300 nm or less and the value Rq of 300 nm or less is used as the raw material for producing signal crystal silicon.

Furthermore, the yield attained in the FZ method is increased up to substantially 100% when polycrystalline silicon having the value Rpv of 2000 nm or less, the value Ra of 100 nm or less and the value Rq of 150 nm or less is used as the raw material for producing single crystal silicon.

Accordingly, the following method is effective: A plate-shaped sample is cut out from a polycrystalline silicon mass; a surface of the plate-shaped sample is subjected to a lapping treatment with an abrasive; the surface of the plate-shaped sample resulting from the lapping treatment is subjected to an etching treatment with a mixture of hydrofluoric acid and nitric acid; surface roughness of the surface of the plate-shaped sample resulting from the etching treatment is evaluated through observation with an atomic force microscope (AFM); and when a maximum surface roughness value Rpv is 500 nm or less, an arithmetic average roughness value Ra is 600 nm or less and a root mean square roughness value Rq is 600 nm or less, the polycrystalline silicon mass is evaluated as good.

For example, if polycrystalline silicon having the value Rpv of 2500 nm or less, the value Ra of 300 nm or less and the value Rp of 300 nm or less is selected as a raw material, high yield can be attained in both the CZ method and the FZ method.

Besides, if polycrystalline silicon having the value Rpv of 2000 nm or less, the value Ra of 100 nm or less and the value Rp of 150 nm or less is selected as a raw material, the yield obtained in the FZ method can be increased up to substantially 100%.

In this manner, the present invention provides a method for comparatively simply selecting polycrystalline silicon suitably used for stably producing single crystal silicon in high yield.

## Claims

1. Polycrystalline silicon having a maximum surface roughness value Rpv (Peak-to-Valley) of 5000 nm or less, an arithmetic average roughness value Ra of 600 nm or less and a root mean square roughness value Rq of 600 nm or less, the surface roughness values being measured by observing with an atomic force microscope (AFM) a surface of a collected plate-shaped sample.

2. The polycrystalline silicon according to claim 1,
wherein the value Rpv is 2500 nm or less, the value Ra is 300 nm or less and the value Rq is 300 nm or less.

3. The polycrystalline silicon according to claim 2,
wherein the value Rpv is 2000 nm or less, the value Ra is 100 nm or less and the value Rq is 150 nm or less.

4. A method for selecting polycrystalline silicon,
wherein a plate-shaped sample is cut out from a polycrystalline silicon mass; a surface of the plate-shaped sample is subjected to a lapping treatment with an abrasive; the surface of the plate-shaped sample resulting from the lapping treatment is subjected to an etching treatment with a mixture of hydrofluoric acid and nitric acid; surface roughness of the surface of the plate-shaped sample resulting from the etching treatment is evaluated through observation with an atomic force microscope (AFM); and when a maximum surface roughness value Rpv is 500 nm or less, an arithmetic average roughness value Ra is 600 nm or less and a root mean square roughness value Rq is 600 nm or less, the polycrystalline silicon mass is evaluated as good.

5. The method for selecting polycrystalline silicon according to claim 4, wherein the value Rpv is 2500 nm or less, the value Ra is 300 nm or less and the value Rq is 300 nm or less.

6. The method for selecting polycrystalline silicon according to claim 5, wherein the value Rpv is 2000 nm or less, the value Ra is 100 nm or less and the value Rq is 150 nm or less.
